(19) **Europäisches Patentamt / European Patent Office / Office européen des brevets**

(11) **EP 2 568 301 B1**

(12) **FASCICULE DE BREVET EUROPEEN**

(45) Date de publication et mention
de la délivrance du brevet:
**09.04.2014 Bulletin 2014/15**

(51) Int Cl.:
*G01R 19/00* (2006.01)    *H05K 1/16* (2006.01)
*H01F 17/00* (2006.01)    *H01F 27/28* (2006.01)
*H02K 3/26* (2006.01)    *G01R 15/18* (2006.01)
*H05K 1/02* (2006.01)    *H05K 3/46* (2006.01)

(21) Numéro de dépôt: **12183231.5**

(22) Date de dépôt: **05.09.2012**

(54) **Capteur de courant et circuit imprimé pour un tel capteur**

Stromsensor und Leiterplatte für einen solchen Sensor

Current sensor and printed circuit board for such a sensor

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **07.09.2011 FR 1157935**

(43) Date de publication de la demande:
**13.03.2013 Bulletin 2013/11**

(73) Titulaire: **Commissariat à l'Énergie Atomique
et aux Énergies Alternatives
75015 Paris (FR)**

(72) Inventeur: **Klein, Philippe
38830 Saint Pierre d'Allevard (FR)**

(74) Mandataire: **Colombo, Michel et al
Brevinnov
310 avenue Berthelot
69008 Lyon (FR)**

(56) Documents cités:
**DE-A1- 10 310 503    US-A1- 2008 316 655**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

L'invention concerne un capteur de courant ainsi qu'un circuit imprimé pour la réalisation de ce capteur de courant.

Un circuit imprimé, également plus connu sous l'acronyme PCB (Printed Circuit Board), est un support permettant de relier électriquement un ensemble de composants électriques. Un tel circuit imprimé se présente généralement sous la forme d'une plaque stratifiée. Ce circuit imprimé peut être monocouche ou multicouche. Un circuit imprimé monocouche ne comporte qu'une seule couche de métallisation dans laquelle sont imprimées des pistes conductrices qui raccordent électriquement les différents composants électriques entre eux. Un circuit imprimé multicouche comporte, au contraire, plusieurs couches de métallisation c'est-à-dire au moins deux couches et, de préférence, plus de quatre ou six couches. Dans la suite de cette description, on s'intéresse principalement à ces circuits imprimés multicouches.

Une couche de métallisation est l'une des couches de la plaque stratifiée formant le circuit imprimé dans laquelle sont réalisées une ou plusieurs pistes conductrices qui raccordent électriquement les différents composants électriques entre eux. Cette couche est plane et s'étend parallèlement au plan de la plaque stratifiée. Généralement, la couche de métallisation est obtenue en déposant une couche uniforme d'un matériau conducteur, typiquement un métal tel que du cuivre, puis en gravant cette couche uniforme pour ne laisser subsister que les pistes conductrices.

Les différentes couches de métallisation du circuit imprimé sont espacées mécaniquement les unes des autres par des couches isolantes en matériau électriquement isolant. Ce matériau isolant présente une rigidité diélectrique élevée c'est-à-dire typiquement supérieure à 3 MV/m et, de préférence, supérieure à 10 MV/m. Par exemple, le matériau électriquement isolant est réalisé à partir de résine époxyde et/ou de fibre de verre. La couche isolante se présente généralement sous la forme d'une plaque rigide réalisée dans un matériau qui ne devient pas visqueux lors de son assemblage avec d'autres couches. Par exemple, elle est réalisée à partir d'une résine thermodurcissable qui a déjà subi un thermodurcissement irréversible.

Les différentes couches du circuit imprimé multicouche sont assemblées les unes aux autres, sans aucun degré de liberté, à l'aide de couches adhésives appelées « pré-imprégné » et plus connues sous le terme anglais de « prepreg ».

Un pré-imprégné est constitué d'une résine thermodurcissable imprégnant, généralement, un renfort tel qu'un tissu. Typiquement, la résine est une résine époxyde. Lors de la fabrication du circuit imprimé, la transformation de la résine thermodurcissable fait intervenir une polymérisation irréversible qui transforme le pré-imprégné en un matériau solide et rigide qui colle entre elles de façon irréversible les différentes couches du circuit imprimé. Typiquement, chaque transformation intervient lorsque le pré-imprégné est chauffé à une température élevée et est comprimé avec une pression élevée. Ici, une température élevée est une température supérieure à 100°C et, de préférence, supérieure à 150°C. Une pression élevée est une pression supérieure à 0,3 MPa et, typiquement, supérieure à 1 MPa.

Les pistes conductrices des différentes couches de métallisation peuvent être électriquement raccordées par l'intermédiaire de plots conducteurs traversant les couches isolantes. Les plots conducteurs sont plus connus sous le terme de « vias ». Les vias s'étendent généralement perpendiculaires au plan des couches. Il existe différentes façons de fabriquer ces vias. L'une des plus communes consiste à réaliser un trou dans la ou les couches isolantes à traverser puis à recouvrir d'un métal la paroi intérieure de ces trous. On parle alors de trous métallisés.

Un via ne traverse pas nécessairement toutes les couches du circuit imprimé. Ainsi, il existe des vias borgnes qui débouchent sur une seule face extérieure du circuit imprimé. Aujourd'hui, il est également possible de réaliser des vias « enterrés », par exemple, à l'aide de technologies connues telles que la technologie connue sous l'acronyme de HDI (« High Density of Integration »). Un via enterré ne débouche sur aucune des faces extérieures du circuit imprimé. Par exemple, un via enterré permet de raccorder électriquement des pistes conductrices réalisées dans des couches de métallisation enfouies à l'intérieur du circuit imprimé.

Des capteurs connus de courant comportent :

- un circuit imprimé comprenant :

  • un empilement le long d'une direction verticale de plusieurs couches de métallisation séparées mécaniquement les unes des autres par des couches électriquement isolantes, et
  • au moins une bobine de mesure ou d'excitation enroulée autour d'un axe vertical d'enroulement, chaque bobine étant formée de pistes conductrices réalisées dans au moins l'une des couches de métallisation, et

- une ou plusieurs lignes de courant disposées parallèlement au plan des couches de métallisation, cette ou ces lignes de courant étant destinées à être alimentées par un ou des courants à mesurer.

Par exemple, un tel capteur de courant est connu du document suivant :

T. O'DONNELL, A. TIPEK, A. CONNELL, P. Mc CLOSKEY, S. C. O'MATHUNA,
« Planar fluxgate current sensor integrated in printed circuit board », Sensors and Actuators A 129 (2006) 20-24.

Dans les capteurs connus, les bobines de mesure et d'excitation sont chacune réalisées dans une seule couche de métallisation. A cause de cela, ces bobines sont dites « planaire ». Pour former les spires de ces bobines, chaque bobine décrit une spirale dans une couche de métallisation.

De l'état de la technique est également connu de :

- US2008/316655A1,
- DE10310503A1.

Les capteurs connus fonctionnent correctement. Toutefois, il est souhaitable d'améliorer leur précision ou leur compacité ou de diminuer leur consommation d'énergie ainsi que leur temps de réponse.

L'invention a donc pour objet un capteur de courant dans lequel les spires de chaque bobine sont formées par des pistes conductrices, réalisées dans des couches de métallisation respectives, raccordées électriquement les unes aux autres par des plots traversant au moins l'une des couches isolantes pour former la bobine qui s'étend le long de l'axe vertical.

Le capteur de courant ci-dessus utilise des bobines « verticales », c'est-à-dire des bobines qui s'étendent et s'enroulent le long d'un axe vertical d'enroulement. Pour un même nombre de spires, une bobine verticale capte ou génère un champ magnétique plus homogène que celui d'une bobine planaire. Par conséquent, le capteur ci-dessus est plus précis.

Les modes de réalisation de ce capteur peuvent comporter une ou plusieurs des caractéristiques suivantes :

■ le circuit imprimé comporte un trou ménagé le long de chaque axe vertical d'enroulement, et le capteur comprend un noyau magnétique logé à l'intérieur de ce trou, ce noyau magnétique ayant des dimensions transversales, c'est-à-dire parallèlement au plan des couches, plus petites, d'au moins 5 μm, que les dimensions transversales correspondantes du trou pour ménager un jeu entre des parois verticales du trou et des faces verticales en vis-à-vis du noyau magnétique ;

■ ladite au moins une bobine comporte une première paire de bobines de mesure formée d'une première et d'une seconde bobines de mesure disposées de part et d'autre de la ligne de courant et agencées de manière à ce que la somme ou la différence des champs magnétiques mesurés par chacune de ces bobines conserve la contribution du champ magnétique $B_i$ généré par la ou les lignes de courant et réduit la contribution de tout champ magnétique homogène sur toute la surface du circuit imprimé ;

■ un trou traversant est ménagé au centre de chaque bobine et le capteur comporte un même anneau magnétique traversant les trous au centre des bobines de mesure de la première paire ;

■ ladite au moins une bobine comporte une première et une seconde paires de bobines disposées l'une après l'autre le long de la ou des lignes de courant, chaque paire de bobines comprenant une première et une seconde bobines de mesure disposées de part et d'autre de la ou des lignes de courant, un trou traversant étant ménagé au centre de chaque bobine, et le capteur comporte un premier et un second anneaux magnétiques, le premier anneau magnétique traversant les trous au centre des bobines de mesure de la première paire et le second anneau magnétique traversant les trous au centre des bobines de mesure de la seconde paire ;

■ ladite au moins une bobine comporte une première et une seconde paires de bobines disposées l'une après l'autre le long de la ou des lignes de courant, chaque paire de bobine comprenant une première et une seconde bobines de mesure disposées de part et d'autre de la ou des lignes de courant, un trou traversant étant ménagé au centre de chaque bobine, et le capteur comporte des premier et second anneaux magnétiques, le premier anneau magnétique traversant les trous au centre des premières bobines de chaque paire et le second anneau traversant les trous au centre des secondes bobines de chaque paire de manière à ce que chaque anneau magnétique est situé d'un côté respectifs d'un plan vertical passant par la ou les lignes de courant.

Ces modes de réalisation présentent en outre les avantages suivants :

- loger le noyau magnétique dans un trou élimine ou limite fortement les contraintes mécaniques susceptibles d'être exercées sur ce noyau par les parois verticales du trou notamment en réponse à une variation de température, ce qui accroît la précision du capteur ;
- disposer les première et seconde bobines de mesure de part et d'autre de la ligne de courant permet de compenser un champ magnétique externe homogène sur toute la surface du circuit imprimé tel que le champ magnétique terrestre;
- utiliser un anneau magnétique passant par le centre des bobines de mesure et entourant la ligne conductrice accroît la sensibilité du capteur ;
- utiliser deux anneaux magnétiques situés chacun d'un côté respectif de la ligne de courant permet d'ajuster lors de la conception du circuit imprimé la tension générée par chaque bobine de mesure en réglant la distance qui sépare cette bobine de mesure de la ligne de courant.

L'invention a également pour objet un circuit imprimé pour le capteur de courant ci-dessus comportant :

- un empilement le long d'une direction verticale de plusieurs couches de métallisation séparées mécaniquement les unes des autres par des couches électriquement isolantes,

- au moins une bobine de mesure ou d'excitation enroulée autour d'un axe vertical d'enroulement, les spires de chaque bobine étant formées par des pistes conductrices, réalisées dans des couches de métallisation respectives, raccordées électriquement les unes aux autres par des plots traversant au moins l'une des couches isolantes pour former la bobine qui s'étend le long de l'axe vertical, et
- une ou plusieurs lignes de courant destinées à être alimentées par un ou des courants à mesurer, chaque ligne de courant étant formée par des pistes conductrices réalisées dans au moins une couche de métallisation de l'empilement.

Les modes de réalisation de ce circuit imprimé peuvent comporter une ou plusieurs des caractéristiques suivantes :

■ ladite au moins une bobine comprend :

- une première paire de bobines formée d'une première et d'une seconde bobines disposées de part et d'autre de la ligne de courant, la première bobine étant le symétrique de la seconde bobine par rapport à un premier plan vertical, et

- une seconde paire de bobines symétrique de la première paire de bobines par rapport à un second plan vertical perpendiculaire au premier plan vertical ;

■ ladite au moins une bobine comprend une bobine de mesure et une bobine d'excitation concentriques, c'est-à-dire que des spires de chacune de ces bobines sont réalisées dans la même couche de métallisation et s'enroulent autour du même axe d'enroulement ;

■ la dite au moins une bobine comprend une première et une seconde bobines de mesure, et chaque ligne de courant comprend :

- au moins une première et une seconde pistes conductrices passant entre les première et seconde bobines de mesure, ces première et seconde pistes étant réalisées dans des couches de métallisation respectives disposées les unes au-dessus des autres, et
- une connexion électrique raccordant en série ces deux pistes conductrices sans passer entre les bobines de mesure, cette connexion formant avec les deux pistes conductrices une boucle entourant complètement au moins l'une des bobines de mesure de manière à ce que, lorsqu'elle est alimentée, le courant passe plusieurs fois dans le même sens entre les bobines de mesure.

Les modes de réalisation de ce circuit imprimé présentent en outre les avantages suivants :

- les deux symétries axiales entre les bobines permettent d'augmenter l'homogénéité du champ magnétique mesuré ou généré par ces bobines ce qui contribue à améliorer la précision d'un capteur incorporant ces bobines,
- le fait que la bobine de mesure et la bobine d'excitation soient concentriques permet de limiter la consommation d'énergie du capteur et de diminuer le temps de réponse de ce capteur
- réaliser la ligne de courant de manière à ce que le courant passe plusieurs fois dans le même sens entre les bobines de mesure, permet d'accroître la sensibilité d'un capteur réalisé à partir de ce circuit imprimé.

L'invention sera mieux comprise à la lecture de la description qui va suivre, donnée uniquement à titre d'exemple non limitatif et faite en se référant aux dessins sur lesquels :

- la figure 1 est une illustration schématique de l'architecture d'un capteur de courant;
- la figure 2 est une illustration schématique en vue de dessus d'une couche de métallisation d'un circuit imprimé utilisé pour réaliser le capteur de la figure 1 ;
- les figures 3 et 4 sont des illustrations schématiques de pistes conductrices de bobines du capteur de la figure 1 réalisées, respectivement, dans des couches de métallisation paire et impaire ;
- la figure 5 est une illustration schématique en vue de côté et en vue éclatée de différentes couches du circuit imprimé du capteur de la figure 1 ;
- la figure 6 est une illustration schématique en vue de dessus d'une ligne de courant du circuit imprimé de la figure 5 ;
- la figure 7 est une illustration schématique et en perspective d'un autre mode de réalisation d'une bobine verticale;
- la figure 8 est une illustration schématique et simplifiée en vue de dessus d'un autre mode de réalisation du capteur de la figure 1 ;
- la figure 9 est une illustration en vue de dessus d'une couche de métallisation d'un circuit imprimé pour un autre mode de réalisation du capteur de courant.

Dans ces figures, les mêmes références sont utilisées pour désigner les mêmes éléments.
Dans la suite de cette description, les caractéristiques et fonctions bien connues de l'homme du métier ne sont pas décrites en détail.

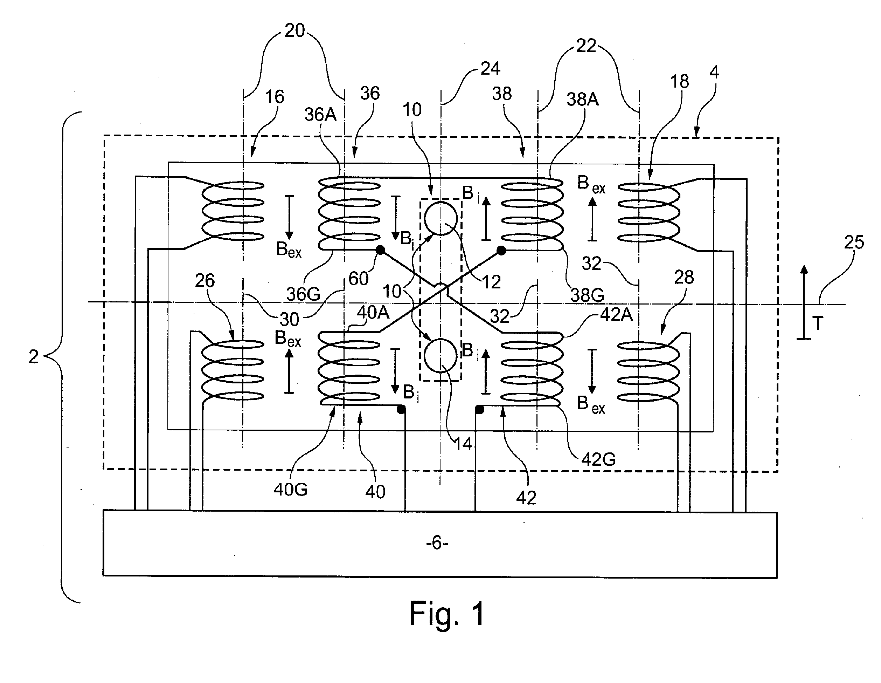

La figure 1 illustre un capteur de courant 2. Cette illustration a uniquement été réalisée pour expliquer le fonctionnement du capteur. Des exemples de modes de réalisation plus détaillés de ce capteur sont décrits plus loin.

Le capteur 2 comprend un circuit imprimé 4 et une unité électronique de traitement 6.

Le circuit imprimé 4 est un circuit imprimé multicouche dont les couches de métallisation sont horizontales.

Dans ce mode de réalisation, le circuit imprimé 4 comprend une ligne 10 dans laquelle circule le courant à mesurer. Sur la figure 1, seules deux sections transversales 12, 14 de cette ligne 10 sont représentées. Ces sections transversales sont deux sections transversales successives de la ligne 10.

La ligne 10 génère un champ magnétique $B_i$ dont les lignes de champ forment des cercles autour de la ligne de courant. Ainsi, les champs magnétiques $B_i$ au niveau de deux points situés de part et d'autre de la ligne 10 et à la même distance de cette ligne 10 sont égaux en amplitude mais opposés en direction. L'amplitude du champ magnétique $B_i$ est fonction de l'intensité du courant i qui circule dans la ligne 10.

Le circuit imprimé 4 comporte également deux paires de bobines. La première paire est formée de deux bobines 16, 18 de mesure. Les bobines 16, 18 sont enroulées, respectivement, autour d'axes verticaux 20 et 22 perpendiculaires au plan des couches de métallisation du circuit imprimé 4. Ces bobines 16 et 18 sont identiques sauf qu'elles sont disposées de part et d'autre de la ligne 10. De préférence, les bobines 16 et 18 sont symétriques l'une de l'autre par rapport à un plan vertical 24 passant par la ligne 10. Les spires des bobines 16 et 18 sont enroulées autour d'un noyau magnétique saturable. Ce noyau magnétique n'a pas été représenté sur la figure 1. Typiquement, le noyau magnétique est un noyau magnétique réalisé en matériau ferromagnétique dont la perméabilité relative statique, c'est-à-dire pour une fréquence nulle, est très élevée. Par perméabilité relative statique très élevée, on désigne le fait que la perméabilité relative statique est supérieure à 1000 et, de préférence, supérieure à 10000 ou 100000. Par exemple, le noyau magnétique est réalisé dans un matériau tel qu'un mu-métal ou un matériau magnétique connu sous le nom commercial de Vitrovac® 6025.

Typiquement, chaque bobine 16, 18 comporte plus de deux spires et de préférence plus de trois ou six spires empilées les unes au-dessus des autres dans la direction verticale.

Le champ magnétique mesuré par les bobines 16 et 18 sont notés, respectivement, $M_1$ et $M_2$ dans la suite de cette description.

La seconde paire de bobines de mesure est le symétrique de la première paire par rapport à un plan vertical 25 perpendiculaire au plan 24. La seconde paire se situe en aval ou en amont de la première paire le long de la ligne 10. Ici, les bobines de mesure de cette seconde paire portent, respectivement, les références 26 et 28. Les axes verticaux autour desquels s'enroulent les bobines 26 et 28 portent, respectivement, les références 30 et 32.

Le circuit imprimé 4 comprend également quatre bobines d'excitation 36, 38, 40 et 42. Ces bobines 36, 38, 40 et 42 sont chacune formées de plusieurs spires enroulées, respectivement, autour des axes 20, 22, 30 et 32. Typiquement, le nombre de spires de chaque bobine d'excitation empilées les unes au-dessus des autres dans la direction verticale est supérieur ou égal à deux et, de préférence, supérieur ou égal à trois ou six. Ici, chaque bobine d'excitation est concentrique à une bobine de mesure respective. Par « concentrique », on désigne le fait que les spires de chacune de ces bobines sont réalisées dans la même couche de métallisation et s'enroulent autour du même axe d'enroulement. De préférence, toutes les spires d'une bobine concentrique sont réalisées dans les mêmes couches de métallisation que les spires de l'autre bobine qui lui est concentrique. Ici, les bobines de mesure sont enroulées autour des bobines d'excitation. Pour clarifier la figure 1, les bobines 36 à 42 sont représentées à côté des bobines de mesure auxquelles elles sont associées.

Les bobines d'excitation sont symétriques les unes des autres par rapport aux plans 24 et 25 comme pour les bobines de mesures. Elles sont raccordées électriquement en série dans ce mode de réalisation. Ainsi, chaque bobine d'excitation génère un champ magnétique $B_{ex}$ de même amplitude dans le noyau magnétique de la bobine de mesure à laquelle elle est associée. Plus précisément, les bobines 38 et 40 sont électriquement raccordées de manière à générer toutes les deux un champ $B_{ex}$ de même direction tandis que les bobines d'excitation 36 et 42 sont raccordées de manière à générer un champ magnétique $B_{ex}$ dans une direction opposée. Dans cette description, par « raccorder », on désigne le fait de raccorder électriquement.

Chaque bobine d'excitation comprend des spires d'extrémités supérieure et inférieure. Ces spires d'extrémités supérieure et inférieure portent les mêmes références numériques que la bobine d'excitation sauf qu'elles sont suivies, respectivement, des symboles « A » et « G ». Dans ce mode de réalisation, les bobines d'excitation sont raccordées en série de la façon suivante :

- la spire inférieure 40G est directement raccordée à une source de courant d'excitation,
- la spire supérieure 40A est directement raccordée à la spire inférieure 38G,
- la spire supérieure 38A est directement raccordée à la spire supérieure 36A,
- la spire inférieure 36G est directement raccordée à la spire supérieure 42A, et
- la spire inférieure 42G est directement raccordée à la source de courant.

Dans le paragraphe ci-dessus, par « directement », on désigne le fait que les spires sont raccordées les unes aux autres sans passer par l'intermédiaire d'une autre des bobines 36 à 42.

Dans ces conditions, les champs magnétiques

$M_1$, $M_2$, $M_3$ et $M_4$ mesurés respectivement par les bobines 16, 18, 26 et 28 sont donnés par les relations suivantes :

$$- M_1 = T - B_i - B_{ex},$$
$$- M_2 = T + B_i + B_{ex},$$
$$- M_3 = T - B_i + B_{ex},$$
$$- M_4 = T + B_i - B_{ex},$$

où T est un champ magnétique homogène sur toute la surface du circuit imprimé 4.

Par champ magnétique homogène, on désigne le fait que ce champ T est de même direction et de même amplitude en tout point du circuit imprimé 4. Typiquement, ce champ magnétique T est le champ magnétique terrestre.

L'unité 6 de traitement acquiert les mesures $M_1$, $M_2$, $M_3$ et $M_4$ réalisées à l'aide des bobines 16, 18, 26 et 28 et en déduit l'intensité du courant i circulant dans la ligne 10. Pour cela, l'unité 6 compense les mesures $M_1$, $M_2$, $M_3$ et $M_4$ pour éliminer les contributions des champs magnétiques $B_{ex}$ et T et ne retenir que la contribution du champ magnétique $B_i$. Par exemple, à cet effet, l'unité 6 combine les champs magnétiques mesurés $M_1$, $M_2$, $M_3$ et $M_4$ à l'aide de simples opérations arithmétiques. Dans le mode de réalisation décrit, le champ magnétique compensé est obtenu à l'aide de la relation suivante : $M_2 + M_4 - M_1 - M_3 = 4B_i$. De préférence, les bobines 16, 18, 26 et 28 de mesure sont raccordées électriquement les unes aux autres de manière à réaliser la somme précédente. Ainsi, seul le résultat de cette somme est transmis à l'unité 6.

Ainsi, l'unité 6 est apte à compenser automatiquement les contributions des champs magnétiques $B_{ex}$ et T.

Dans ce cas particulier, l'unité 6 génère également le courant d'excitation.

Typiquement, l'unité 6 est réalisée à partir d'un circuit électronique intégré.

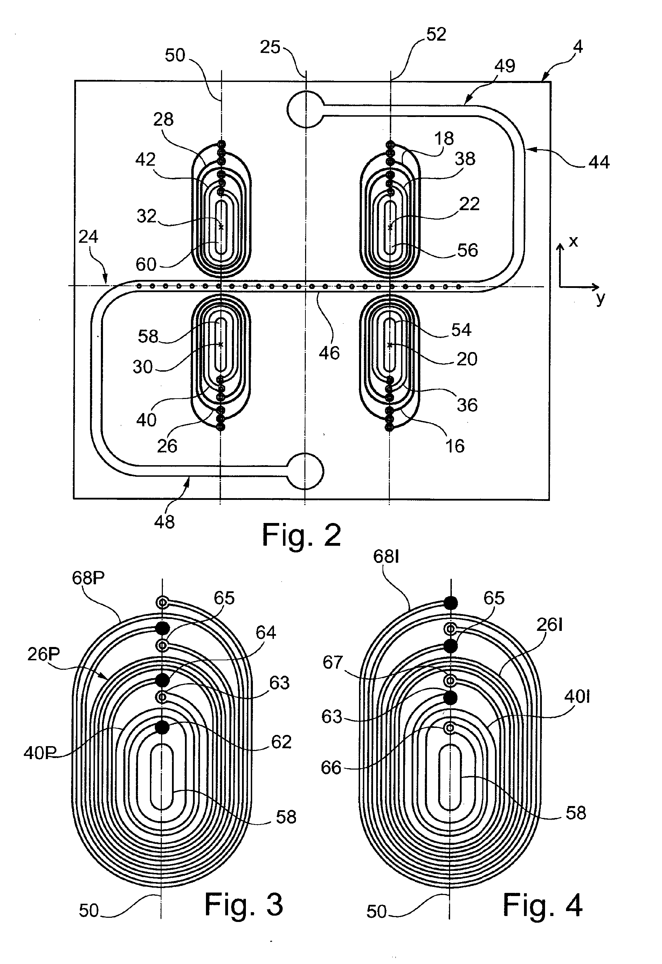

La figure 2 représente une couche de métallisation du circuit imprimé 4. Le circuit imprimé 4 est réalisé par un empilement, dans une direction verticale Z, de sept couches de métallisation s'étendant chacune dans un plan horizontal parallèle à des directions orthogonales X et Y. La couche de métallisation représentée est une couche de métallisation intermédiaire, c'est-à-dire comprise entre des couches de métallisation supérieure et inférieure formant, respectivement, les faces supérieure et inférieure du circuit 4. Dans la suite de cette description, les faces supérieure et inférieure ne sont pas représentées sur les figures.

La ligne 10 est formée de plusieurs pistes conductrices réalisées dans des couches de métallisation différentes raccordées en série par des vias verticaux. Sur la figure 2, seule une piste 44 est visible. Chaque piste conductrice comprend :

- un segment rectiligne 46 qui passe entre les deux bobines de mesure d'une même paire, et
- deux portions de boucles 48, 49 pour raccorder en série les différents segments de la ligne 10.

Ici, le segment 46 traverse des plans verticaux 50 et 52. Le plan 50 est le plan qui contient les axes 30 et 32 tandis que le plan 52 est le plan qui contient les axes verticaux 20 et 22. Le segment 46 est perpendiculaire aux plans 50 et 52.

Le sens de traversée des plans 50 et 52 par la ligne 10 correspond à la direction du courant qui la parcourt lorsque la ligne 10 est alimentée par un courant continu.

Les portions de boucle 48 et 49 sont agencées pour que le courant qui circule dans chaque segment de la ligne 10 traverse toujours dans le même sens les plans 50 et 52. Elles permettent de ramener le courant circulant dans un segment supérieur de la ligne 10 vers un segment situé en dessous. Ces portions de boucle 48 à 49 ne passent pas entre les axes 20 et 22 ni entre les axes 30 et 32. Pour cela, elles contournent par l'extérieur les bobines de mesure. L'extérieur est ici défini comme étant la région du circuit imprimé 4 qui se trouve à l'opposé du côté des bobines de mesure le plus proche du plan 24.

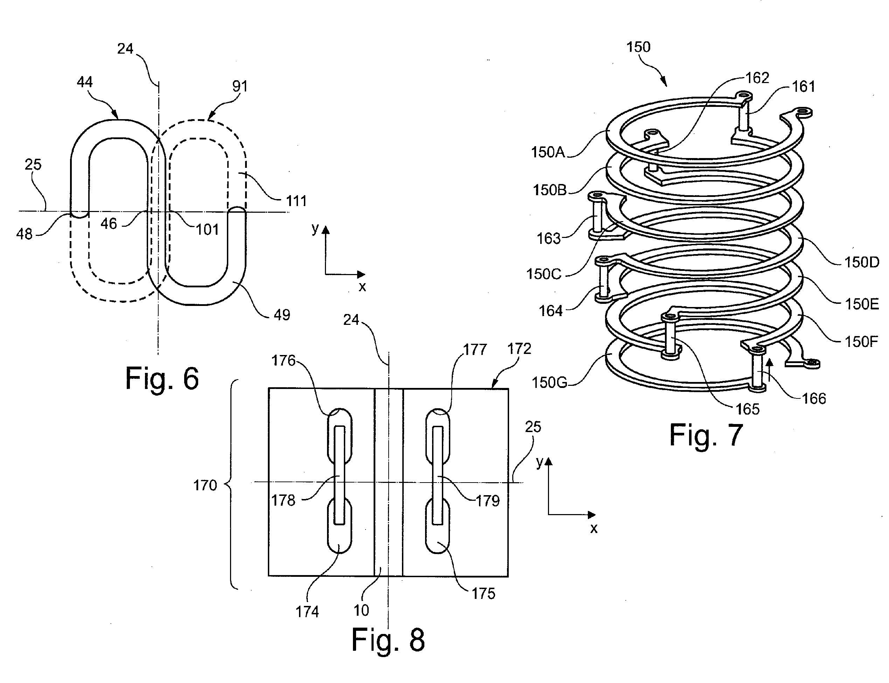

La ligne 10 est décrite plus en détail en référence à la figure 6.

Comme représenté sur cette figure 2, les deux paires de bobines de mesure sont disposées l'un après l'autre dans une direction Y le long de laquelle s'étend les segments 46.

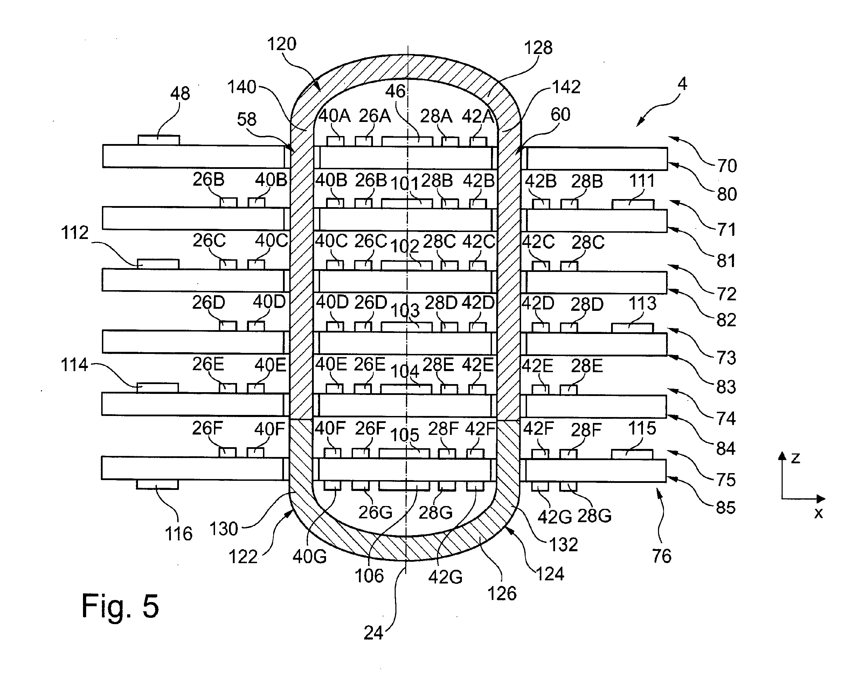

Le circuit 4 comporte également quatre trous 54, 56, 58 et 60 traversant verticalement et de part en part le circuit 4. Ces trous sont destinés à recevoir des noyaux magnétiques. Un exemple d'un tel noyau magnétique est représenté sur la figure 5. Ces trous sont creusés le long des axes verticaux, respectivement, 20, 22, 30 et 32. Ces trous sont oblongs. Les plus grandes largeurs des trous 54 et 56 sont comprises dans le plan 52 et les plus grandes largeurs des trous 58, 60 sont comprises dans le plan 50.

Les figures 3 et 4 représentent plus en détail les pistes conductrices des bobines 26 et 40 réalisées, respectivement, dans des couches de métallisation intermédiaires paire et impaire. Ces bobines sont ici formées en empilant, en alternance, les couches de métallisations paires et impaires les unes au-dessus des autres dans la direction Z. Dans ces figures, les pistes conductrices portent la même référence que la bobine mais suivie d'un « P » pour la couche de métallisation paire et d'un « I » pour la couche de métallisation impaire. Dans ces figures, les extrémités des pistes conductrices se terminent soit par un point soit par un cercle. Les point et cercle représentent les extrémités, respectivement, inférieure et supérieure d'un via.

La piste 40P s'enroule à partir d'un via 62 autour du trou 58 jusqu'à un via 63 en allant de l'intérieur vers l'extérieur dans le sens anti-horaire.

De façon similaire, la piste 26P s'enroule autour de la piste 40P en partant d'un via 64 jusqu'à un via 65 en allant de l'intérieur vers l'extérieur dans le sens anti-horaire.

Dans la couche de métallisation impaire, juste en dessous, la piste 401 s'enroule à partir du via 63 jusqu'à un via 66 autour du trou 58 en allant de l'extérieur vers l'intérieur dans le sens anti-horaire.

La piste 261 s'enroule en partant du via 65 jusqu'à un via 67 autour de la piste 401 en allant de l'extérieur vers l'intérieur dans le sens anti-horaire.

Dans chaque couche de métallisation paire et impaire, les pistes des bobines 26 et 40 font plusieurs tours autour du trou 58.

Sur les figures 3 et 4, des pistes 68P et 681 d'une bobine de compensation ont également été représentées. Ces pistes s'enroulent autour des pistes de la bobine de mesure. La bobine de compensation permet de générer un champ magnétique qui annule le champ magnétique dans le noyau magnétique introduit dans le trou 58. Dans ces conditions, l'intensité du courant circulant dans la ligne 10 se déduit de l'intensité du courant alimentant la bobine 68. Ceci permet notamment de travailler en champ nul dans le noyau magnétique.

Dans ce mode de réalisation, les pistes 261, 401 et 601 se déduisent des pistes 26P, 40P et 68P par une symétrie axiale par rapport au plan 50. Ainsi, la superposition, dans un même plan horizontal, des pistes conductrices des couches de métallisation paire et impaire forme un motif présentant une symétrie axiale le long d'un axe contenu dans le plan 50.

Les vias 62 à 67 sont tous contenus dans le plan 50.

Dans la suite de cette description, la bobine de compensation est similaire à celle de mesure et ne sera donc pas décrite plus en détail.

Les pistes des autres bobines 16, 18, 28, 36, 38, 42 se déduisent des pistes des bobines 26 et 40 par symétrie par rapport aux plans 24 et 25.

La figure 5 représente plus en détail et dans une vue éclatée l'empilement des différentes couches du circuit imprimé 4. Ici, le circuit imprimé 4 comprend sept couches de métallisation intermédiaires 70 à 76 séparées mécaniquement par des couches isolantes, respectivement, 80 à 85.

Les pistes conductrices sont réalisées dans chacune des couches de métallisation 70 à 76 pour former la ligne 10, les bobines de mesure 26 et 28 et les bobines d'excitation 40 et 42. Sur la figure 5, le circuit imprimé est représenté en coupe selon le plan 50.

Sur la figure 5, les spires d'une bobine portent la référence de cette bobine suivie des lettres A, B, C, D, E, F et G en partant de la spire d'extrémité supérieure jusqu'à la spire d'extrémité inférieure. Ainsi, les spires dont les références finissent en A, B, C, D, E, F et G sont réalisées, respectivement, dans les couches de métallisation 70, 71, 72, 73, 74, 75 et 76. Les pistes de chaque bobine sont raccordées en série par l'intermédiaire de vias verticaux non représentés sur cette figure. Pour simplifier cette figure, les pistes conductrices d'une même bobine sont représentées par de simples rectangles même si la piste fait plusieurs tours autour des trous 58 et 60.

La ligne 10 comprend également sept pistes conductrices réalisées dans les couches de métallisation 70 à 76. Dans les couches de métallisation 70 à 76, la ligne 10 comprend :

- un segment rectiligne, portant respectivement les références 46 et 101 à 106, passant entre chaque paire de bobines de mesure perpendiculairement aux plans 25, 50 et 52, et
- une portion de boucle, portant respectivement les références 48, 111 à 116.

Les segments 46, 101 à 106 et les portions de boucle 48, 110 à 116 sont réalisés, respectivement, dans les couches 70 à 76. Les segments 46, 101 à 106 sont empilés les uns au-dessus des autres dans la direction Z. Ils sont également symétriques par rapport au plan 24.

Dans ce mode de réalisation, lorsque les pistes conductrices de la ligne 10, réalisées dans deux couches de métallisation immédiatement consécutives dans la direction verticale, sont superposées dans un même plan horizontal, ces pistes sont les symétriques l'une de l'autre par rapport au plan 24. Ainsi, les portions de boucle 48, 112, 114 et 116 entourent par l'extérieur les bobines 16 et 26 tandis que les portions de boucle 111, 113 et 115 entourent par l'extérieur les bobines 18 et 28.

La structure de la ligne 10 ainsi obtenue est décrite plus en détail en référence à la figure 6.

La figure 5 représente également le noyau magnétique 120 logé dans les trous 58 et 60. Ce noyau magnétique est conçu pour canaliser les champs magnétiques $B_i$ et $B_{ex}$. Ici, il a la forme d'un anneau comprenant deux jambes verticales 122 et 124 traversant de part en part le circuit imprimé 4 par l'intermédiaire, respectivement, des trous 58 et 60. Les extrémités inférieures des jambes 122 et 124, qui font saillie au-delà de la face inférieure du circuit imprimé, sont reliées mécaniquement et magnétiquement par un jambage 126 qui passe par-dessus les pistes conductrices 40G, 26G, 106, 28G et 42G. Les extrémités supérieures des jambes 122 et 124 sont reliées mécaniquement et magnétiquement l'une à l'autre par un jambage 128 qui passe par-dessus les pistes conductrices 40A, 26A, 46, 28A et 42A. Ainsi, le noyau magnétique 120 entoure complètement les segments 46, 101 à 106 de la ligne 10.

Le noyau 120 est réalisé par une partie inférieure en « U » et une partie supérieure en « U » en matériau magnétique. Chaque partie comporte un fond formant respectivement les jambages 126 et 128. La partie inférieure comporte deux branches verticales 130 et 132 et la partie supérieure comporte deux branches verticales 140 et 142. Les branches verticales 130 et 132 sont insérées dans les trous, respectivement, 58 et 60 à partir de la face inférieure du circuit imprimé. A l'inverse, les branches 140, 142 sont insérées, respectivement, dans les trous 58 et 60 à partir de la face supérieure du circuit imprimé. Dans l'épaisseur du circuit imprimé, les branches 130 et 140 se superposent dans la direction Y pour établir la continuité du circuit magnétique entre les deux parties en « U ». Ici, les branches 130 et 140 se chevauchent sur plus d'un tiers de leur hauteur. Il en est de même pour les branches 132 et 142.

Les plus grandes dimensions transversales du noyau magnétique 120 à l'intérieur des trous 58 et 60 sont strictement inférieures d'au moins 5 μm et, de préférence, d'au moins 100 μm aux dimensions transversales correspondantes des trous 58 et 60. Ici par dimensions transversales, on désigne les dimensions qui se situent dans un plan horizontal. Ici, les plus grandes dimensions transversales du noyau 120 correspondent à la zone où les branches verticales 130, 140 et 132, 142 se chevauchent. Ces différences de dimensions entre les trous et le noyau magnétique 120 créent un jeu entre les parois verticales des trous et les faces en vis-à-vis du noyau magnétique. Ce jeu limite les contraintes mécaniques exercées par le circuit imprimé 4 sur le noyau magnétique. Cela contribue à améliorer la précision du capteur 2.

Le noyau magnétique inséré dans les trous 54, 56 est agencé comme décrit pour le noyau 120.

La figure 6 illustre en vue de dessus la piste 44 et en pointillés une piste 91 de la ligne 10 réalisée dans la couche de métallisation située juste en dessous. Pour des raisons de clarté, les segments 46 et 101 ont été décalés l'un par rapport à l'autre dans la direction X pour que la superposition dans la direction verticale de ces segments soit visible. Comme illustré sur cette figure, l'empilement des pistes conductrices de la ligne 10 de deux couches de métallisation immédiatement consécutives dans la direction Z forme un « 8 » en vue de dessus.

La figure 7 représente un autre mode de réalisation d'une bobine verticale 150. Dans ce mode de réalisation, une seule spire 150A à 150G est formée dans chaque couche de métallisation. Les spires 150A à 150G sont raccordées électriquement entre elles par des vias 161 à 166. Plus précisément, les vias 161 à 166 raccordent respectivement :

- les spires 150A et 150B,
- les spires 150B et 150C,
- les spires 150C et 150D,
- les spires 150D et 150E,
- les spires 150E et 150F, et
- les spires 150F et 150G.

Dans ce mode de réalisation, les vias 161 à 166 sont uniformément répartis, en vue de dessus, le long de la périphérie extérieure de la bobine 150. Dans ces conditions, ces vias peuvent être des vias traversants, des vias borgnes ou des vias enterrés.

Les différentes bobines du circuit imprimé 4 peuvent être réalisées comme décrit pour la bobine 150.

La figure 8 représente un capteur de courant 170. Ce capteur de courant 170 comprend un circuit imprimé 172 et une unité de traitement similaire à l'unité de traitement 6 et non représentée. Le circuit imprimé 172 est par exemple identique au circuit imprimé 4 sauf qu'il est modifié pour présenter deux capteurs « fluxgate ». Ces deux capteurs « fluxgate » sont disposés chacun d'un côté respectif du plan 24. A cet effet les trous 54, 56, 58 et 60 sont remplacés, respectivement, par des trous oblongs 174 à 177 dont la plus grande largeur est parallèle au plan 24.

Dans ce mode de réalisation, le capteur 170 comprend deux noyaux magnétiques 178 et 179. Ces noyaux forment chacun un anneau. Toutefois, dans ce mode de réalisation, le noyau 178 traverse les trous 174 et 176 tandis que le noyau 179 traverse les trous 175 et 177. Ces noyaux 178 et 179 sont par exemple réalisés comme décrit en référence à la figure 5. Ces noyaux 178 et 179 n'entourent donc pas la ligne de courant 10.

La distance qui sépare les trous 174 à 177 de la ligne 10 est ajustée de manière à régler la tension générée par les bobines de mesure. Ainsi, ce capteur 170 peut facilement être adapté à la mesure de courant de forte intensité, c'est-à-dire des courants dont l'intensité dépasse 1 A et de préférence 100 A ou 1000 A.

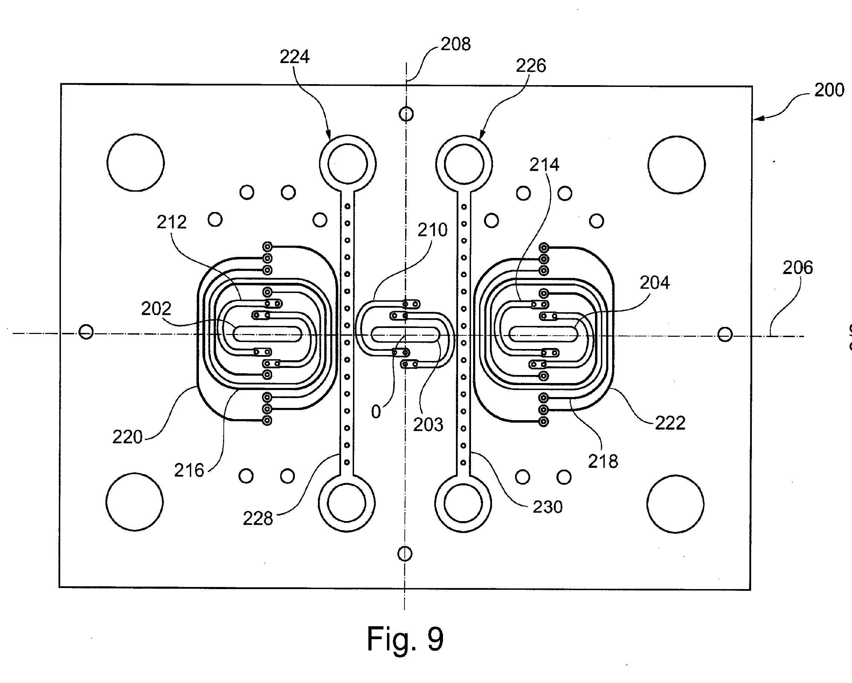

La figure 9 représente une couche de métallisation d'un circuit imprimé 200. Le circuit imprimé 200 comprend trois trous oblongs 202 à 204. La plus grande largeur de ces trous 202 à 204 est comprise dans un plan vertical 206. Le plan 206 forme également un plan de symétrie des trous 202 à 204. Les trous 202 à 204 sont également symétriques par rapport à un plan vertical 208 perpendiculaire au plan 206. Le trou 203 s'étend le long de l'axe O défini par l'intersection des plans 206 et 208.

Une bobine verticale d'excitation 210 est enroulée autour du trou 203 et deux autres bobines verticales d'excitation 212 et 214 sont enroulées, respectivement, autour des trous 202 et 204.

Des bobines verticales de mesure 216 et 218 sont enroulées autour des trous, respectivement, 202 et 204. Sur cette figure, des bobines verticales de compensation 220 et 222 sont représentées comme étant enroulées, respectivement, autour des bobines 216 et 218.

Le circuit imprimé 200 comporte également deux lignes conductrices 224 et 226 dans lesquelles circulent deux courants à mesurer. Comme précédemment, ces lignes conductrices sont formées de pistes conductrices réalisées dans les différentes couches de métallisation. Sur la figure 9, seules les pistes conductrices 228 et 230, respectivement, des lignes 224 et 226 sont visibles. Ces pistes 228 et 230 sont rectilignes et s'étendent perpendiculairement au plan 206. La piste 228 est disposée entre les trous 202 et 203 tandis que la piste 230 est disposée entre les trous 203 et 204.

Les trois branches du noyau magnétique insérées dans les trous 202 à 204 sont raccordées magnétiquement les unes aux autres, par-dessus et par-dessous le circuit imprimé 200, par des jambages magnétiques sensiblement horizontaux.

Typiquement, le circuit imprimé 200 est destiné à la réalisation d'un capteur de courant différentiel. Pour cela, les lignes 224 et 226 sont raccordées à des courants à mesurer circulant en sens opposé dans ces lignes. Dans ces conditions, la bobine 216 réalise la mesure suivante : $M_a = B_1 - B_2 + B_{ex}$. La mesure relevée par la bobine 218 est donnée par la relation $M_b = -B_1 + B_2 + B_{ex}$. Les champs magnétiques $B_1$ et $B_2$ sont les champs magnétiques générés par les courants circulant, respectivement, dans les lignes 224 et 226. Le champ magnétique $B_{ex}$ est le champ magnétique généré par les bobines d'excitation 210, 212 et 214.

La différence entre les mesures $M_1$ et $M_2$ permet donc d'obtenir une mesure compensée de la différence entre les champs magnétiques $B_1$ et $B_2$. A partir de cette différence, une unité électronique de traitement en déduit la différence entre les intensités des courants circulant dans les lignes 224 et 226. Un tel capteur différentiel de courant est utile pour la réalisation d'un disjoncteur différentiel.

De nombreux autres modes de réalisation sont possibles. Par exemple, les bobines de compensation peuvent être utilisées. Ceci permet de travailler en champ nul. La bobine de compensation est réalisée comme décrit pour les autres bobines du capteur.

Dans un autre mode de réalisation, une même bobine remplit plusieurs fonctions. Par exemple, une même bobine remplit la fonction de bobine de mesure et de bobine d'excitation. Dans ce cas, la bobine d'excitation peut être omise. Une même bobine peut aussi remplir les fonctions de bobine de mesure et de compensation.

Les bobines d'une même paire ne sont pas forcément disposées symétriquement par rapport au plan 24. Dans ce cas, si les bobines de mesure ne sont pas symétriques par rapport à ce plan 24, le noyau magnétique doit entourer la ligne conductrice. Dans un autre mode de réalisation, si cette symétrie n'est pas respectée, il est aussi possible d'entourer le circuit imprimé d'un blindage électromagnétique qui atténue les champs magnétiques homogènes extérieurs tels que le champ magnétique terrestre.

La disposition des bobines de mesure, d'excitation et de compensation enroulées autour d'un même axe peut être modifiée. Par exemple, la bobine d'excitation est enroulée autour de la bobine de mesure.

Les spires des différentes bobines enroulées autour d'un même axe peuvent être entrelacées comme décrit en référence à la figure 6 de la demande de brevet US 7 372 261.

En variante, chaque bobine ne comporte qu'une seule spire par couche de métallisation.

Les bobines de mesure d'une même paire ne sont pas forcément identiques. Dans ce cas, ces différences doivent être compensées par l'unité de traitement.

Dans un mode de réalisation simplifié, les bobines 26, 28, 40 et 42 sont omises. Dans ce cas, les directions de mesure des bobines 16 et 18 sont en sens opposé. Les bobines d'excitation 36, 38 sont agencées pour que le champ magnétique d'excitation soit dans le même sens dans les deux bobines 16, 18. Dans ces conditions, la somme des mesures des bobines 16 et 18 réduit ou annule la contribution du champ magnétique d'excitation dans la tension générée.

Une même piste conductrice de la ligne 10 de courant peut traverser plusieurs fois les plans 50 et 52 dans le même sens. Par exemple, à cet effet, cette piste entoure plusieurs fois les bobines de mesure. A l'inverse, il est aussi possible que la ligne 10 ne passe qu'une seule fois entre les bobines de mesures.

En variante, les portions de boucle 48, 111 à 116 peuvent contourner la même bobine de mesure par l'extérieur. Il n'est pas non plus nécessaire d'alterner les contournements des bobines de mesure situées à droite et à gauche du plan 24 comme décrit ici. Par exemple, les portions de boucle 110 à 112 sont à gauche de la bobine de mesure 26 et les portions de boucle 113 à 115 sont à droite de la bobine de mesure 28 dans la figure 5.

Dans une autre variante, les segments 46, 101 à 105 ne sont pas raccordés en série mais en parallèle.

La moitié des segments 46, 101 à 105 est utilisée pour faire circuler un courant dans un sens et l'autre moitié pour faire circuler un courant en sens opposé. La différence entre les intensités de ces deux courants est alors mesurée.

Les portions de boucle 48 à 49 peuvent être au moins deux ou trois fois plus éloignées des bobines de mesure que les segments des pistes conductrices de la ligne 10.

La ligne 10 peut aussi être remplacée, par exemple, par deux lignes de courant dans lesquelles deux courants circulent. Dans ces conditions, le capteur de courant mesure la résultante de la combinaison des champs magnétiques $B_{i1}$, et $B_{i2}$ générés, respectivement, par les courants $i_1$ et $i_2$ circulant dans chacune des lignes de courant. Si ces courants $i_1$ et $i_2$ circulent dans des directions opposées, alors le capteur de courant est un capteur de courant différentiel.

La ligne 10 peut également être remplacée par un conducteur mécaniquement indépendant du circuit imprimé. Dans ce cas, avantageusement, le circuit imprimé comporte une rainure ou un trou traversant passant entre les bobines de mesure 16 et 18 et entre les bobines de mesure 26 et 28 propres à recevoir ce conducteur. Le conducteur est alors, par exemple, un barreau conducteur disposé parallèlement au plan du circuit imprimé.

D'autres modes de réalisation de l'anneau magnétique 120 sont possibles. Par exemple, il peut être réalisé en enroulant un fil ou une bande magnétique dans les trous 30, 32. Dans ce cas, de préférence, la bande ou le fil forme une ou plusieurs spires passant chacune par les trous 30, 32.

Le noyau magnétique inséré dans les trous du circuit imprimé n'est pas nécessairement un anneau. En variante, chaque anneau est remplacé par deux barreaux magnétiquement isolés l'un de l'autre. Ces barreaux sont insérés dans les mêmes trous que l'anneau.

Dans un autre mode de réalisation, le noyau magnétique est omis. On obtient alors une structure de Rogowski.

Il est aussi possible de superposer plusieurs circuits imprimés multicouches afin d'augmenter le rapport longueur/largeur des anneaux magnétiques, ainsi que le nombre de spires du capteur.

On peut aussi disposer le long d'un même conducteur électrique, dans lequel le courant doit être mesuré, plusieurs des capteurs de courant décrits ci-dessus.

**Revendications**

1. Capteur de courant comportant :

   - un circuit imprimé (4 ; 170) comprenant :

      • un empilement le long d'une direction verticale de plusieurs couches de métallisation séparées mécaniquement les unes des autres par des couches électriquement isolantes, et
      • au moins une bobine (16, 18, 26, 28 ; 150 ; 216, 218) de mesure ou d'excitation enroulée autour d'un axe vertical d'enroulement, chaque bobine étant formée de pistes conductrices réalisées dans au moins l'une des couches de métallisation, et

   - une ou plusieurs lignes (10 ; 224, 226) de courant disposées parallèlement au plan des couches de métallisation, cette ou ces lignes de courant étant destinées à être alimentées par un ou des courants à mesurer, **caractérisé en ce que** les spires de chaque bobine (16, 18, 26, 28 ; 150 ; 216, 218) sont formées par des pistes conductrices, réalisées dans des couches de métallisation respectives, raccordées électriquement les unes aux autres par des plots traversant au moins l'une des couches isolantes pour former la bobine qui s'étend le long de l'axe vertical.

2. Capteur selon la revendication 1, dans lequel :

   - le circuit imprimé comporte un trou (54, 56, 58, 60 ; 174-177 ; 202-204) ménagé le long de chaque axe vertical d'enroulement, et
   - le capteur comprend un noyau magnétique (120) logé à l'intérieur de ce trou, ce noyau magnétique ayant des dimensions transversales, c'est-à-dire parallèlement au plan des couches, plus petites, d'au moins 5 μm, que les dimensions transversales correspondantes du trou pour ménager un jeu entre des parois verticales du trou et des faces verticales en vis-à-vis du noyau magnétique.

3. Capteur selon l'une quelconque des revendications précédentes, dans lequel ladite au moins une bobine comporte une première paire de bobines de mesure formée d'une première et d'une seconde bobines (16, 18) de mesure disposées de part et d'autre de la ligne (10) de courant et agencées de manière à ce que la somme ou la différence des champs magnétiques mesurés par chacune de ces bobines conserve la contribution du champ magnétique $B_i$ généré par la ou les lignes de courant et réduit la contribution de tout champ magnétique homogène sur toute la surface du circuit imprimé.

4. Capteur selon la revendication 3, dans lequel un trou (54, 56) traversant est ménagé au centre de chaque bobine et le capteur comporte un même anneau magnétique traversant les trous au centre des bobines de mesure de la première paire.

5. Capteur selon la revendication 1 ou 2, dans lequel :

   - ladite au moins une bobine comporte une première et une seconde paires (16, 18, 26, 28) de bobines disposées l'une après l'autre le long de la ou des lignes de courant, chaque paire de bobines comprenant une première et une seconde bobines de mesure disposées de part et d'autre de la ou des lignes (10) de courant, un trou traversant (54, 56, 58, 60) étant ménagé au centre de chaque bobine,
   - le capteur comporte un premier et un second anneaux magnétiques (120), le premier anneau magnétique traversant les trous au centre des bobines de mesure de la première paire et le second anneau magnétique traversant les trous au centre des bobines de mesure de la seconde paire.

6. Capteur selon la revendication 1 ou 2, dans lequel :

   - ladite au moins une bobine comporte une première et une seconde paires de bobines (16, 18, 26, 28) disposées l'une après l'autre le long de la ou des lignes de courant, chaque paire de bobine comprenant une première et une seconde bobines de mesure disposées de part et d'autre de la ou des lignes de courant, un trou (174-177) traversant étant ménagé au centre de chaque bobine, et
   - le capteur comporte des premier et second anneaux magnétiques (178, 179), le premier anneau magnétique traversant les trous au centre des premières bobines de chaque paire et le second anneau traversant les trous au centre des secondes bobines de chaque paire de manière à ce que chaque anneau magnétique est situé d'un côté respectifs d'un plan vertical passant par la ou les lignes de courant.

7. Circuit imprimé pour un capteur conforme à l'une quelconque des revendications précédentes, ce circuit imprimé comportant :

    - un empilement le long d'une direction verticale de plusieurs couches de métallisation séparées mécaniquement les unes des autres par des couches électriquement isolantes,
    - au moins une bobine de mesure ou d'excitation enroulée autour d'un axe vertical d'enroulement, chaque bobine étant formée de pistes conductrices réalisées dans au moins l'une des couches de métallisation, et
    - une ou plusieurs lignes de courant destinées à être alimentées par un ou des courants à mesurer, chaque ligne de courant étant formée par des pistes conductrices réalisées dans au moins une couche de métallisation de l'empilement, **caractérisé en ce que** les spires de chaque bobine sont formées par des pistes conductrices, réalisées dans des couches de métallisation respectives, raccordées électriquement les unes aux autres par des plots traversant au moins l'une des couches isolantes pour former la bobine qui s'étend le long de l'axe vertical.

8. Circuit selon la revendication 7, dans lequel ladite au moins une bobine comprend :

    - une première paire de bobines formée d'une première et d'une seconde bobines (16, 18) disposées de part et d'autre de la ligne (10) de courant, la première bobine étant le symétrique de la seconde bobine par rapport à un premier plan vertical (24), et
    - une seconde paire de bobines (26, 28) symétrique de la première paire de bobines par rapport à un second plan vertical (25) perpendiculaire au premier plan vertical.

9. Circuit selon la revendication 7 ou 8, dans lequel ladite au moins une bobine comprend une bobine de mesure (16, 18, 26, 28 ; 216, 218) et une bobine d'excitation (36, 38, 40, 42 ; 212, 214) concentriques, c'est-à-dire que des spires de chacune de ces bobines sont réalisées dans la même couche de métallisation et s'enroulent autour du même axe d'enroulement.

10. Circuit selon l'une quelconque des revendications 7 à 9, dans lequel

    - la dite au moins une bobine comprend une première et une seconde bobines (16, 18, 26, 28) de mesure, et
    - chaque ligne (10) de courant comprend :

        • au moins une première et une seconde pistes conductrices (46, 101-106) passant entre les première et seconde bobines de mesure, ces première et seconde pistes étant réalisées dans des couches de métallisation respectives disposées les unes au-dessus des autres, et
        • une connexion électrique (48, 49, 111-116) raccordant en série ces deux pistes conductrices sans passer entre les bobines de mesure, cette connexion formant avec les deux pistes conductrices une boucle entourant complètement au moins l'une des bobines de mesure de manière à ce que, lorsqu'elle est alimentée, le courant passe plusieurs fois dans le même sens entre les bobines de mesure.

**Patentansprüche**

1. Stromsensor, umfassend:

    - eine gedruckte Schaltung (4; 170), umfassend:

        • eine Stapelung mehrerer mechanisch voneinander durch elektrisch isolierende Schichten getrennter Metallisierungsschichten, und
        • mindestens eine Mess- oder Erregerspule (16, 18, 26, 28; 150; 216, 218), die um eine vertikale Wickelachse gewickelt ist, wobei jede Spule von leitenden Spuren gebildet ist, die in mindestens einer der Metallisierungsschichten ausgeführt ist, und

    - eine oder mehrere Stromlinien (10; 224, 226), die parallel zur Ebene der Metallisierungsschichten angeordnet sind, wobei diese Stromlinie(n) dazu bestimmt ist(sind), mit einem oder mehreren zu messenden Strömen gespeist zu werden, **dadurch gekennzeichnet, dass** die Windungen jeder Spule (16, 18, 26, 28; 150; 216, 218) von leitenden Spuren gebildet sind, die in jeweiligen Metallisierungsschichten angeordnet sind, die elektrisch aneinander durch Stifte, die durch mindestens eine der Isolierschichten hindurchgehen, angeschlossen sind, um die Spule zu bilden, die sich entlang der Vertikalachse erstreckt.

**2.** Sensor nach Anspruch 1, bei dem:

- die gedruckte Schaltung ein Loch (54, 56, 58, 60; 174-177; 202-204) umfasst, das entlang jeder vertikalen Wickelachse ausgenommen ist, und
- der Sensor einen Magnetkern (120) umfasst, der im Inneren dieses Loches angeordnet ist, wobei dieser Magnetkern Querabmessungen, d.h. parallel zur Ebene der Schichten, aufweist, die um mindestens 5 $\mu$m kleiner sind als die entsprechenden Querabmessungen des Loches, um ein Spiel zwischen vertikalen Wänden des Loches und vertikalen Seiten gegenüber dem Magnetkern auszusparen.

**3.** Sensor nach einem der vorhergehenden Ansprüche, bei dem die mindestens eine Spule ein erstes Paar von Messspulen umfasst, das von einer ersten und einer zweiten Messspule (16, 18) gebildet ist, die beiderseits der Stromlinie (10) angeordnet und derart vorgesehen sind, dass die Summe oder die Differenz der von jeder dieser Spulen gemessenen Magnetfelder den Beitrag des Magnetfeldes $B_i$, das von der oder den Stromlinien erzeugt wird, bewahrt oder den Beitrag jedes homogenen Magnetfeldes auf der gesamten Oberfläche der gedruckten Schaltung verringert.

**4.** Sensor nach Anspruch 3, bei dem ein Durchgangsloch (54, 56) in der Mitte jeder Spule ausgenommen ist, und der Sensor einen selben Magnetring umfasst, der durch die Löcher in der Mitte der Spulen des ersten Paars hindurchgeht.

**5.** Sensor nach Anspruch 1 oder 2, bei dem:

- die mindestens eine Spule ein erstes und ein zweites Paar (16, 18, 26, 28) von Spulen umfasst, die nacheinander entlang der Stromlinie(n) angeordnet sind, wobei jedes Spulenpaar eine erste und eine zweite Messspule umfasst, die beiderseits der Stromlinie(n) (10) angeordnet sind, wobei ein Durchgangsloch (54, 56, 58, 60) in der Mitte jeder Spule ausgenommen ist,
- der Sensor einen ersten und einen zweiten Magnetring (120) umfasst, wobei der erste Magnetring durch die Löcher in der Mitte der Messspulen des ersten Paars und der zweite Magnetring durch die Löcher in der Mitte der Messspulen des zweiten Paars hindurchgeht.

**6.** Sensor nach Anspruch 1 oder 2, bei dem:

- die mindestens eine Spule ein erste und ein zweites Paar von Spulen (16, 18, 26, 28) umfasst, die nacheinander entlang der Stromlinie(n) angeordnet sind, wobei jedes Spulenpaar eine erste und eine zweite Messspule umfasst, die beiderseits der Stromlinie(n) angeordnet sind, wobei ein Durchgangsloch (174-177) in der Mitte jeder Spule angeordnet ist und
- der Sensor erste und zweite Magnetringe (178, 179) umfasst, wobei der erste Magnetring durch die Löcher in der Mitte der ersten Spulen jedes Paars und der zweite Ring durch die Löcher in der Mitte der zweiten Spulen jedes Paars hindurchgeht, sodass jeder Magnetring auf einer jeweiligen Seite einer Vertikalebene, die durch die Stromlinie(n) hindurch verläuft, angeordnet ist.

**7.** Gedruckte Schaltung für einen Sensor nach einem der vorhergehenden Ansprüche, wobei diese gedruckte Schaltung umfasst:

- eine Stapelung mehrerer durch elektrisch isolierende Schichten mechanisch voneinander getrennter Metallisierungsschichten,
- mindestens eine Mess- oder Erregerspule, die um eine vertikale Wickelachse gewickelt ist, wobei jede Spule von leitenden Spuren gebildet ist, die in mindestens einer der Metallisierungsschichten ausgeführt sind, und
- eine oder mehrere Stromlinien, die dazu bestimmt sind, von einem oder mehreren zu messenden Strömen gespeist zu werden, wobei jede Stromlinie von leitenden Spuren gebildet ist, die in mindestens einer Metallisierungsschicht der Stapelung ausgeführt sind,
**dadurch gekennzeichnet, dass** die Spuren jeder Spule von leitenden Spuren gebildet sind, die in jeweiligen Metallisierungsschichten ausgeführt sind, die elektrisch aneinander durch Stifte, die durch mindestens eine der isolierenden Schichten hindurchgehen, angeschlossen sind, um die Spule zu bilden, die sich entlang der Vertikalachse erstreckt.

**8.** Schaltung nach Anspruch 7, bei der die mindestens eine Spule umfasst:

- ein erstes Spulenpaar, das von einer ersten und einer zweiten Spule (16, 18) gebildet ist, die beiderseits der Stromlinie (10) angeordnet sind, wobei die erste Spule die Entsprechung zur zweiten Spule in Bezug zu einer ersten Vertikalebene (24) ist, und
- ein zweites Spulenpaar (26, 28), das zum ersten Spulenpaar in Bezug zu einer zweiten Vertikalebene (25), die auf die erste Vertikalebene senkrecht steht, symmetrisch ist.

**9.** Schaltung nach Anspruch 7 oder 8, bei der mindestens eine Spule eine Messspule (16, 18, 26, 28; 216, 218) und eine Erregerspule (36, 38, 40, 42; 212, 214) umfasst, die konzentrisch sind, d.h. dass die Windungen jeder dieser Spulen in derselben Metallisierungsschicht ausgeführt und um dieselbe Wickelachse gewickelt sind.

10. Schaltung nach einem der Ansprüche 7 bis 9, bei der

- die mindestens eine Spule eine erste und eine zweite Messspule (16, 18, 26, 28) umfasst, und
- jede Stromlinie (10) umfasst:

• mindestens eine erste und eine zweite leitende Spur (46, 101-106), die zwischen der ersten und der zweiten Messspule hindurch verlaufen, wobei diese erste und zweite Spur in jeweiligen Metallisierungsschichten, die übereinander angeordnet sind, ausgeführt sind, und
• einen elektrischen Anschluss (48, 49, 111-116), der diese beiden leitenden Spuren in Serie anschließt, ohne zwischen den Messspulen zu verlaufen, wobei dieser Anschluss mit den beiden leitenden Spuren eine Schleife bildet, die mindestens eine der Messspulen vollständig umgibt, so dass, wenn sie angespeist wird, der Strom mehrmals in derselben Richtung zwischen den Messspulen durchläuft.

## Claims

1. A current sensor comprising:

- a printed circuit (4; 170) comprising:

□ a stack, along a vertical direction, of several metallization layers mechanically separated from one another by electrically insulating layers, and
□ at least one measurement coil or excitation coil (16, 18, 26, 28; 150; 216, 218) wound around a vertical winding axis, each coil being formed by conductive tracks made in at least one of the metallization layers, and

- one or more current lines (10; 224, 226) positioned parallel to a plane of the metallization layers, this or these current lines being configured to be supplied with one or more currents to be measured,
**characterized in that** the turns of each coil (16, 18, 26, 28; 150; 216, 218) are formed by conductive tracks, made in respective metallization layers, electrically connected to one another by pads traversing at least one of the insulating layers, to form a coil that extends along the vertical axis.

2. The sensor according to claim 1, in which:

- the printed circuit comprises a hole (54, 56, 58, 60; 174-177; 202-204) made along each vertical winding axis, and
- the current sensor comprises a magnetic core (120) housed within this hole, this magnetic core having transverse dimensions, i.e. parallel to the plane of the layers, that are smaller, by at least 5 μm, than corresponding transverse dimensions of the hole, to create a clearance between the vertical walls of the hole and the vertical faces facing the magnetic core.

3. The sensor according to any one of the previous claims, in which said at least one coil comprises a first pair of measurement coils formed by first and second measurement coils (16, 18) positioned on either side of a current line (10) and arranged so that the sum or difference of magnetic fields measured by each of these coils preserves a contribution of the magnetic field $B_i$ generated by the current line or lines and reduces a contribution of any homogenous magnetic field on the entire surface of the printed circuit.

4. The sensor according to claim 3, in which a through hole (54, 56) is arranged at the centre of each coil and the sensor comprises a same magnetic ring traversing the holes at the centre of the measurement coils of the first pair.

5. The sensor according to claim 1 or 2, in which:

- said at least one coil comprises a first and second pair (16, 18, 26, 28) of coils positioned one after another along the current line or lines, each pair of coils comprising a first and second measurement coil positioned on either side of the current line or lines (10), a through hole (54, 56, 58, 60) being made through a centre of each coil,
- the sensor comprises a first and a second magnetic ring (120), the first magnetic ring traversing holes through the centre of the measurement coils of the first pair and the second magnetic ring traversing holes through the centre of the measurement coils of the second pair.

6. The sensor according to claim 1 or 2, in which:

- said at least one coil comprises a first and a second pair of coils (16, 18, 26, 28) positioned one after the other along the current line or lines, each pair of coils comprising first and second measurement coils positioned on either side of the current line or lines, a through hole (174-177) being made through the centre of each coil, and
- the sensor comprises first and second magnetic rings (178, 179), the first magnetic ring traversing holes through the centre of the first coils of each pair, and the second magnetic ring traversing holes through the centre of the second coils of each pair so that each magnetic ring is situated on a respective side of a vertical plane passing through the current line or lines.

7. A printed circuit for a sensor in conformance with any one of the previous claims, this printed circuit comprising:

- a stack, along a vertical direction, of several metallization layers mechanically separated from one another by electrically insulating layers,
- at least one measurement or excitation coil wound around a vertical winding axis, each coil being formed by conductive tracks made in at least one of the metallization layers, and
- one or more current lines configured to be supplied with one or more currents to be measured, each current line being formed by conductive tracks made in at least one metallization layer of the stack,
**characterized in that** the turns of each coil are formed by conductive tracks, made in respective metallization layers, electrically connected to one another by pads traversing at least one of the insulating layers, to form a coil that extends along the vertical axis.

8. The circuit according to claim 7, in which said at least one coil comprises:

- a first pair of coils formed by a first and a second coil (16, 18) formed on either side of the current line (10), the first coil being symmetrical with the second coil relative to a first vertical plane (24), and
- a second pair of coils (26, 28) symmetrical with the first pair of coils relative to a second vertical plane (25) perpendicular to the first vertical plane.

9. The circuit according to claim 7 or 8, in which said at least one coil comprises a measurement coil (16, 18, 26, 28; 216, 218) and an excitation coil (36, 38, 40, 42; 212, 214) that are concentric, i.e., the turns of each of these coils are made in a same metallization layer and are wound around a same winding axis.

10. The circuit according to any one of claims 7 to 9, in which

- said at least one coil comprises first and second measurement coils (16, 18, 26, 28), and
- each current line (10) comprises:

☐ at least one first and second conductive tracks (46, 101-106) passing between the first measurement coils, these first and second tracks being made in respective metallization layers positioned one above the other, and
☐ an electrical connection (48, 49, 111-116) serially connecting these two conductive tracks without passing between the measurement coils, this connection forming, with the two conductive tracks, a loop completely surrounding at least one of the measurement coils so that, when the loop is powered, current passes several times in the same direction between the measurement coils.

Fig. 1

Fig. 2

Fig. 3

Fig. 4

Fig. 5

Fig. 6

Fig. 7

Fig. 8

EP 2 568 301 B1

18

Fig. 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2008316655 A1
- DE 10310503 A1

- US 7372261 B

**Littérature non-brevet citée dans la description**

- Planar fluxgate current sensor integrated in printed circuit board. *Sensors and Actuators A,* 2006, vol. 129, 20-24